# DEMANDE DE BREVET EUROPEEN

(11) **EP 4 726 402 A1**
(43) Date de publication de la demande: **15.04.2026**
(21) Numéro de dépôt: 25204865.7
(22) Date de dépôt: 26.09.2025
(51) Int. Cl.: G01R 31/28

(54) **CIRCUIT ELECTRONIQUE**

(30) Priorité: 09.10.2024 FR 2410916
(71) Demandeur: STMicroelectronics International N.V., 1228 Plan-les-Ouates, Geneva (CH)
(72) Inventeur: LEDUC, Bruno, 38500 Voiron (FR); DEDIEU, Sebastien, 38660 La Terrasse (FR); FORT, Jimmy, 13114 Puyloubier (FR)
(74) Mandataire: Cabinet Beaumont

(57) **Abrégé**

La présente description concerne un circuit électronique, comprenant :
un premier circuit à tester ;
un deuxième circuit, ayant au moins des composants similaires au premier circuit, et relié au premier circuit ;
le circuit électronique étant configuré pour :
- adopter un premier état dans lequel une détermination d'au moins un indicateur de vieillissement du premier circuit est réalisée en utilisant le deuxième circuit, puis
- adopter un deuxième état dans lequel le premier circuit est soumis à des conditions de fonctionnement entraînant un vieillissement, puis
- adopter de nouveau le premier état,
- comparer les valeurs déterminées de l'indicateur, et
- adapter son fonctionnement en fonction du résultat de la comparaison.

## Description

### Domaine technique

La présente description concerne de façon générale les circuits électroniques, notamment les circuits électroniques entrant dans la composition de systèmes à communication en champ proche (NFC, Near Field Communication, en anglais) ou de recharges sans fil (Wireless Charging, WLC, en anglais), ainsi que leurs procédés de fonctionnement.

### Technique antérieure

Les systèmes NFC, ou plus globalement les systèmes mettant en œuvre une recharge sans fil, utilisent des puissances qui deviennent de plus en plus importantes à mesure que l'on veut réduire les temps de charge.

Cela entraîne notamment le vieillissement d'éléments amplificateurs de ces systèmes.

### Résumé de l'invention

Il existe un besoin de mesurer ce vieillissement afin, par exemple, de prendre des mesures pour préserver les systèmes.

Un mode de réalisation pallie tout ou partie des inconvénients des circuits connus.

Un mode de réalisation prévoit un circuit électronique, comprenant :
un premier circuit à tester ;
un deuxième circuit, ayant au moins des composants similaires au premier circuit, et relié au premier circuit ;
le circuit électronique étant configuré pour :
   - adopter un premier état dans lequel une détermination d'au moins un indicateur de vieillissement du premier circuit est réalisée en utilisant le deuxième circuit, puis
   - adopter un deuxième état dans lequel le premier circuit est soumis à des conditions de fonctionnement entraînant un vieillissement, puis
   - adopter de nouveau le premier état,
   - comparer les valeurs déterminées de l'indicateur, et
   - adapter son fonctionnement en fonction du résultat de la comparaison.

Un mode de réalisation prévoit un procédé de fonctionnement d'un circuit électronique comprenant un premier circuit à tester, un deuxième circuit similaire au premier circuit et relié au premier circuit, le procédé comprenant les étapes suivantes:
- placer le circuit électronique dans un premier état où une détermination d'au moins un indicateur de vieillissement du premier circuit est réalisée en utilisant le deuxième circuit, puis
- placer le circuit électronique dans un deuxième état où le premier circuit est soumis à des conditions de fonctionnement entraînant un vieillissement, puis
- placer de nouveau le circuit électronique dans le premier état,
- comparer les valeurs déterminées de l'indicateur; et
- adapter le fonctionnement du circuit électronique en fonction du résultat de la comparaison.

Dans un mode de réalisation, si la comparaison indique un vieillissement du premier circuit, alors des performances du circuit électronique sont abaissées.

Dans un mode de réalisation, le premier et le deuxième circuits comprennent au moins un transistor, ledit indicateur étant une tension de seuil dudit au moins un transistor.

Dans un mode de réalisation, dans le deuxième état, le deuxième circuit n'est pas soumis auxdites conditions de fonctionnement entraînant un vieillissement.

Dans un mode de réalisation :
le premier circuit comprend un premier transistor de type NMOS en série avec un deuxième transistor de type PMOS, un premier nœud de conduction du deuxième transistor étant configuré pour être relié à un premier rail de tension mis à une première tension de référence, un nœud de commande du deuxième transistor étant connecté au point milieu des premier et deuxièmes transistors ;
le deuxième circuit comprend un troisième transistor de type NMOS en série avec un quatrième transistor de type PMOS, un nœud de conduction du quatrième transistor étant configuré pour être relié au premier rail de tension ;
les premiers et troisièmes transistors ayant chacun un nœud de conduction relié à la masse.

Dans un mode de réalisation, le premier et le troisième transistors sont appairés et le deuxième et le quatrième transistors sont appairés.

Dans un mode de réalisation, le deuxième circuit comprend :
- un cinquième transistor, de type PMOS et ayant un nœud de conduction configuré pour être relié au premier rail de tension ; et
- un sixième transistor, de type NMOS, avec un nœud de conduction relié à la masse et un autre nœud de conduction relié à son nœud de commande, le nœud de commande du cinquième transistor étant connecté au nœud de commande du quatrième transistor, un premier interrupteur reliant un nœud de conduction du cinquième transistor à un nœud de conduction du sixième transistor, un deuxième interrupteur reliant le nœud de commande du quatrième au point milieu des troisièmes et quatrièmes transistors, un troisième interrupteur reliant le nœud de commande du quatrième transistor au premier rail de tension.

Dans un mode de réalisation, le deuxième circuit comprend :
- un septième transistor, de type PMOS et ayant un nœud de conduction configuré pour être relié au premier rail de tension ; et
- un huitième transistor, de type NMOS et ayant un nœud de conduction relié à la masse, un quatrième interrupteur reliant un nœud de conduction du septième transistor à un nœud de conduction du huitième transistor, un cinquième interrupteur reliant la masse au nœud de commande des sixième et huitième transistors, un sixième interrupteur reliant les nœuds de commande des deuxième et septième transistors, un septième interrupteur reliant le nœud de commande du septième transistor au premier rail de tension.

Dans un mode de réalisation, un neuvième transistor est monté en montage cascode avec le premier transistor.

Dans un mode de réalisation, le deuxième circuit comprend :
- un dixième transistor, de type PMOS, dont un premier nœud de conduction est relié au premier rail de tension, dont le nœud de commande est relié au nœud de commande du deuxième transistor, et dont un deuxième nœud de conduction est relié à son nœud de commande par l'intermédiaire d'un huitième interrupteur ;
- un onzième transistor, de type NMOS, ayant un nœud de conduction relié à la masse, un autre nœud de conduction relié au deuxième nœud de conduction du onzième transistor par l'intermédiaire d'un neuvième interrupteur, et un nœud de commande configuré pour être relié à un deuxième rail de tension mis à une deuxième tension ; et
- un douzième transistor, de type NMOS, dont un premier nœud de conduction est relié à la masse, dont un deuxième nœud de conduction est relié au deuxième nœud de conduction du dixième transistor par l'intermédiaire d'un dixième interrupteur, et dont un nœud de commande est relié au nœud de commande du sixième transistors.

Dans un mode de réalisation, le deuxième circuit comprend un treizième transistor, de type PMOS, ayant un nœud de commande relié au nœud de commande du onzième transistor, un nœud de conduction relié au premier rail de tension, et un autre nœud de conduction relié au point milieu des premiers et deuxièmes transistors par l'intermédiaire d'un onzième interrupteur ;
un douzième interrupteur reliant le point milieu des premiers et deuxièmes transistors et un deuxième nœud de conduction du deuxième transistor.

Dans un mode de réalisation :
- dans le premier état, le premier et le deuxième interrupteurs sont passants, et le troisième et le cinquième interrupteurs sont ouverts, le nœud de commande du troisième transistor étant relié à un troisième rail de tension configuré pour recevoir une rampe de tension, et le nœud de commande du premier transistor étant relié au deuxième rail de tension ; et
- dans le deuxième état, le premier et le deuxième interrupteurs, sont ouverts, et le troisième et le cinquième interrupteurs sont passants, le nœud de commande du troisième transistor étant relié à la masse et le nœud de commande du premier transistor étant relié au deuxième rail de tension.

Dans un mode de réalisation :
- dans le premier état, le quatrième, et le sixième interrupteurs sont passants, et le septième interrupteur est ouvert ; et
- dans le deuxième état, le quatrième et le sixième interrupteurs sont ouverts, et le septième interrupteur est passant.

Dans un mode de réalisation :
- dans le premier état, le huitième et le neuvième interrupteurs sont ouverts, et le dixième interrupteur est passant, et
- dans le deuxième état, le huitième et le neuvième interrupteurs sont passants, et le dixième interrupteur est ouvert.

Dans un mode de réalisation :
- dans le premier état, le onzième interrupteur est ouvert, et le douzième interrupteur est passant, et
- dans le deuxième état, le onzième interrupteur est passant, et le douzième interrupteur est ouvert.

Dans un mode de réalisation, dans le deuxième état, le deuxième circuit est également soumis auxdites conditions de fonctionnement entraînant un vieillissement.

Dans un mode de réalisation :
- le premier et le deuxième circuits comprennent chacun une chaîne logique similaire ;
- un nœud de sortie de la chaîne logique du deuxième circuit est relié à un nœud d'entrée de cette même chaîne logique par l'intermédiaire d'un treizième interrupteur de sorte à former un oscillateur en anneau lorsque le treizième interrupteur est passant ;
- un nœud d'entrée de la chaîne logique du premier circuit est relié au nœud d'entrée de la chaîne logique du deuxième circuit par l'intermédiaire d'un quatorzième interrupteur (604); et
- le nœud de sortie de la chaîne logique du deuxième circuit et un nœud de sortie de la chaîne logique du premier circuit sont reliés à une charge différente et de valeur équivalente.

Dans un mode de réalisation, la chaîne logique du premier et du deuxième circuits comprend un nombre impair d'inverseurs, ou de circuits tampons, en série.

Dans un mode de réalisation, ledit indicateur est une fréquence ou un décalage temporel de l'oscillateur.

Dans un mode de réalisation, dans le premier état, l'interrupteur est passant et l'interrupteur est ouvert ; et dans le deuxième état, l'interrupteur est ouvert et l'interrupteur est passant.

Un mode de réalisation prévoit un procédé d'utilisation du circuit électronique tel que décrit ci-dessus, comprenant l'utilisation du deuxième circuit pour déterminer le vieillissement du premier circuit et adapter le fonctionnement du circuit électronique en fonction du vieillissement déterminé.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente très schématiquement un circuit pour la charge sans fil ;
la figure 2 représente sous forme de blocs un élément du circuit de la figure 1 ;
la figure 3 représente un procédé de fonctionnement d'un circuit de la figure 2 selon un mode de réalisation ;
la figure 4 représente un mode de réalisation d'un bloc de la figure 2 ;
la figure 5 représente un mode de réalisation d'un bloc de la figure 2 ; et
la figure 6 représente un mode de réalisation d'un bloc de la figure 2.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

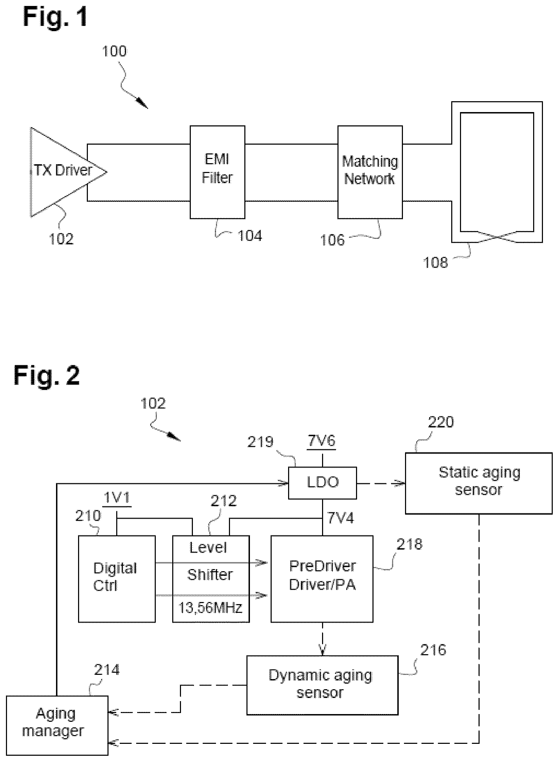

La figure 1 représente très schématiquement un circuit 100 pour la charge ou la communication sans fil.

L'exemple de la figure 1 est présent par exemple dans des systèmes NFC ou de recharge sans fil.

Le circuit 100 comprend, par exemple, un circuit de commande d'émission 102 (TX Driver) relié, préférablement connecté, à un étage de filtrage 104 (EMI Filter). L'étage de filtrage 104 est relié, préférablement connecté, à un circuit d'adaptation d'impédance 106 (Matching Network) lui-même relié, préférablement connecté, à une antenne 108.

Le circuit de commande d'émission 102 crée par exemple un signal carré ou sinusoïdal différentiel à +/- VDD avec une fréquence de 13,56 MHz par exemple.

Pour augmenter la rapidité de recharge, on peut augmenter la puissance émise par l'antenne 108. Le courant est défini par l'impédance de l'antenne et est à son maximum. Il est donc nécessaire d'augmenter la tension aux bornes de l'antenne.

Dans un exemple où la puissance ciblée est de l'ordre de quelques watts, la tension de travail VDD du circuit de commande d'émission 102 est potentiellement portée à plus de 7 Volts ce qui engendre un vieillissement accru de certains de ces composants.

La figure 2 représente sous forme de blocs un élément du circuit de la figure 1. Plus particulièrement, la figure 2 illustre un exemple du circuit de commande d'émission 102.

Le circuit de commande d'émission 102 de la figure 2 comprend un modificateur de niveau 212 (Level Shifter 13,56 MHz) reliant un contrôleur de signal numérique 210 (Digital Ctrl) à un bloc de contrôle et d'amplification 218 (PreDriver Driver/PA). Le bloc de contrôle et d'amplification 218 est relié, préférablement connecté, à un régulateur à faible chute de tension 219 (LDO).

Le contrôleur de signal numérique 210 est relié, préférablement connecté, à un rail de tension mis par exemple à une tension de 1,1 V et le régulateur à faible chute de tension 219 est relié, préférablement connecté, à un rail de tension VDD mis par exemple à une tension de 7, 6 V. La tension de fonctionnement du bloc 218 est par exemple d'environ 7,4 V. De telles tensions provoquent un vieillissement notamment dans des transistors ou des chaînes logiques du bloc de contrôle et d'amplification 218 et du régulateur à faible chute de tension 219.

Le vieillissement de transistors notamment des transistors MOS peut être de trois types. Un premier type (TDDB, time dependent dielectric breakdown en anglais) concerne la dégradation de l'oxyde de grille, un deuxième type (BTI, bias temperature instability en anglais) concerne des défauts sur toute la grille, et un troisième type (HCI, hot carrier injection en anglais) résultant en des défauts localisés dans la région du drain de part l'application de tensions élevées au niveau du drain et de la grille.

L'impact du vieillissement se traduit notamment par une variation de la tension de seuil des transistors MOS mais également par une variation du courant parcourant le drain et une variation du courant à l'état ouvert.

Les modes de réalisation portent sur la fourniture de circuits de mesure dynamique de vieillissement 216 (Dynamic aging sensor) et/ou de circuits de mesure statique de vieillissement 220 (Static aging sensor) dédiés respectivement à la mesure du vieillissement de composants du bloc 218 et du bloc 219.

Les circuits de mesure dynamique de vieillissement 216 (Dynamic aging sensor) et de mesure statique de vieillissement 220 sont reliés à une unité de contrôle de vieillissement 214 (Aging manager) qui, en fonction des mesures de vieillissement remontées par les circuits 216 et 220, agira sur des paramètres de fonctionnement du circuit 102. Ces paramètres de fonctionnement sont par exemple une tension, un courant, ou une fréquence de fonctionnement. Si un seuil de vieillissement défini au préalable est franchi, un des paramètres de fonctionnement peut être diminué. Cela permet de garantir un fonctionnement, certes moins performant, mais qui évite la dégradation totale du système 100 et une perte de service.

Afin de mettre en œuvre le circuit de mesure dynamique de vieillissement 216 et/ou le circuit de mesure statique de vieillissement 220, les modes de réalisation prévoient un circuit électronique, comprenant :
un premier circuit à tester ;
un deuxième circuit, ayant au moins des composants similaires au premier circuit, et relié au premier circuit ;
le circuit électronique étant configuré pour :
   - adopter un premier état dans lequel une détermination d'au moins un indicateur de vieillissement du premier circuit est réalisée en utilisant le deuxième circuit, puis
   - adopter un deuxième état dans lequel le premier circuit est soumis à des conditions de fonctionnement entraînant un vieillissement, puis
   - adopter de nouveau le premier état,
   - comparer les valeurs déterminées de l'indicateur, et
   - adapter son fonctionnement en fonction du résultat de la comparaison.

Cela permet de mesurer en temps réel l'avancée du vieillissement que ce soit en conditions d'exploitation ou lors de tests accélérés.

De plus cela permet d'obtenir la mesure précise du vieillissement au niveau des composants comme les transistors.

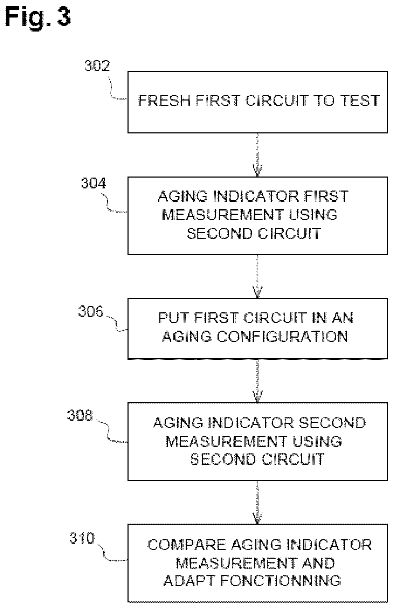

La figure 3 représente un procédé de fonctionnement d'un circuit de la figure 2 selon un mode de réalisation. Plus particulièrement, la figure 3 représente un procédé de fonctionnement du circuit 102.

Dans cet exemple, les blocs 216 ou 220 comprennent un deuxième circuit qui est similaire à un premier circuit à tester dans les blocs associés, respectivement 218 et 219.

Dans le texte, deux composants ou ensemble de composants ou chaînes de composants sont similaires lorsqu'ils sont nominalement identiques aux différences de fabrication près. Par exemple deux composants similaires ont les mêmes dimensions, les mêmes matériaux ou les mêmes niveaux de dopage par exemple, aux différences de fabrication près. Dans le cas de transistors, deux transistors similaires doivent avoir la même largeur et longueur de grille. Deux composants similaires peuvent avoir été pensés pour avoir les mêmes dimensions ou les mêmes niveaux de dopages par exemple mais, après fabrication, leurs dimensions ou niveaux de dopages peuvent varier légèrement d'un composant à l'autre, de par des procédés de fabrication qui ne donnent pas localement un résultat strictement identique.

Une chaîne de composants similaire à une autre chaîne de composants a des composants identiques, aux différences de fabrication près, avec un même motif répété, pour obtenir une même implémentation physique.

Par exemple, le premier circuit comprend un transistor ou une chaîne de transistors du bloc 219, et le deuxième circuit, qui est relié, préférablement connecté au premier circuit, est intégré au bloc 220 et il comprend un transistor similaire ou une chaîne de transistors similaire au premier circuit.

Dans un autre exemple, le premier circuit comprend une chaîne de composants du bloc 218, et le deuxième circuit, qui est relié, préférablement connecté, au premier circuit, est intégré au bloc 216 et il comprend une chaîne de composants similaire à celle du premier circuit.

Dans une étape 302 (FRESH FIRST CIRCUIT TO TEST), le premier circuit n'a pas encore subi de vieillissement ou a un subi un vieillissement non destructif.

Dans une étape 304 (AGING INDICATOR FIRST MEASURMENT USING SECOND CIRCUIT), postérieure à l'étape 302, le circuit 102 adopte un premier état dans lequel la détermination, ou la mesure, d'un ou plusieurs indicateurs de vieillissement du premier circuit est réalisée en utilisant le deuxième circuit. En d'autres termes, on réalise une mesure d'un ou des indicateurs, comme une variation de tension de seuil de transistors ou comme une variation de fréquence d'une chaîne de composants, sur le deuxième circuit qui est similaire au premier circuit.

Dans une étape 306 (PUT FIRST CIRCUIT IN AN AGING CONFIGURATION), postérieure à l'étape 304, le circuit 102 adopte un deuxième état dans lequel le premier circuit est soumis à des conditions de fonctionnement entraînant un vieillissement.

Dans un exemple, qui s'applique par exemple au bloc 220, dans le deuxième état, le deuxième circuit est placé dans une configuration où il ne subit pas de vieillissement. Cela permet de comparer les indicateurs de vieillissement entre le premier circuit qui a subi un vieillissement et le deuxième circuit qui a des indicateurs de vieillissement qui n'ont pas évolué.

Dans un autre exemple, qui s'applique par exemple au bloc 216, dans le deuxième état, le deuxième circuit est placé dans une configuration où il subit le même vieillissement que le premier circuit. Cela permet d'effectuer une mesure ou une détermination d'un ou plusieurs indicateurs de vieillissement sur le deuxième circuit sans interrompre ou perturber le fonctionnement du premier circuit.

Dans une étape 308 (AGING INDICATOR SECOND MEASURMENT USING SECOND CIRCUIT), postérieure à l'étape 306, le circuit 102 adopte de nouveau le premier état. En d'autres termes, l'étape 304 est répétée.

Dans un exemple, qui s'applique par exemple au bloc 220, cela permet de comparer le fonctionnement du premier circuit, qui a subi un vieillissement, et du deuxième circuit, qui lui est resté préservé, et d'en déduire un ou des indicateurs de vieillissement du premier circuit.

Dans un autre exemple, qui s'applique par exemple au bloc 216, le deuxième circuit subit le même vieillissement que le premier circuit, alors une mesure ou une détermination d'un ou plusieurs indicateurs de vieillissement du deuxième circuit donnera a priori une valeur similaire à celui du premier circuit. Cette mesure pourra donc être effectuée tout en n'arrêtant pas, ou ne perturbant pas, le fonctionnement du premier circuit.

Dans une étape 310 (COMPARE AGING INDICATOR MEASURMENTS AND ADAPT FONCTIONNING), postérieure à l'étape 310, en comparant le ou les indicateurs de vieillissement, directement ou indirectement, avant et après vieillissement, alors l'unité de contrôle de vieillissement 214 peut prendre des mesures d'adaptation de tension ou d'intensité ou de fréquence de fonctionnement du circuit 102 afin de préserver un fonctionnement du système 100 dans la durée même s'il est moins performant.

Un premier aspect porte sur une détermination d'un paramètre statique lié au vieillissement.

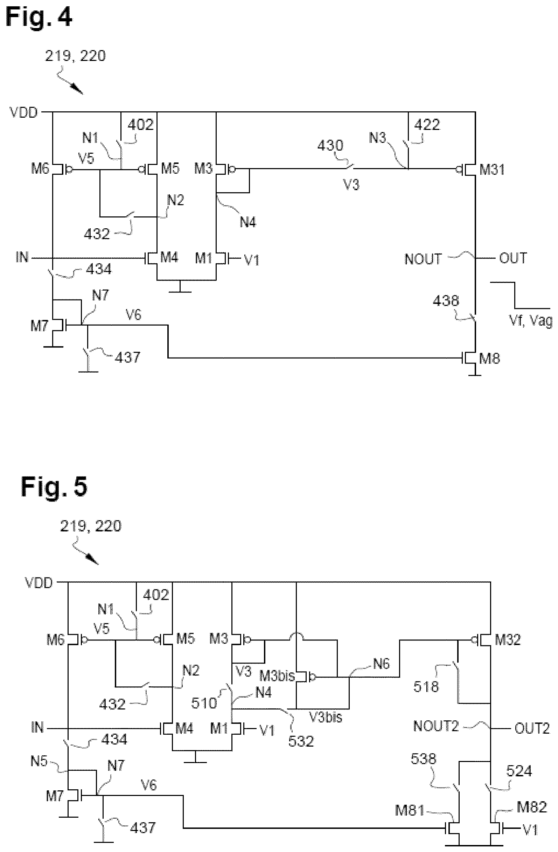

La figure 4 représente un mode de réalisation de blocs de la figure 2. Plus particulièrement, la figure 4 représente un exemple des blocs 220 et 219.

Dans l'exemple représenté, le transistor dont on souhaite connaître le vieillissement est un transistor M1. Le premier circuit comprend le transistor M1, de type NMOS par exemple, en série avec un transistor M3, de type PMOS. Un nœud de conduction du transistor M3 est relié, préférablement connecté, à un premier rail de tension configuré pour être mis à une tension de référence VDD, autrement appelée Vdd_HV, par exemple supérieure à 7 V. Un nœud de commande du transistor M3 est relié, préférablement connecté, au point milieu N4 des transistors M1 et M3. Un nœud de conduction du transistor M1 est relié, préférablement connecté, à la masse.

Dans l'exemple représenté, le deuxième circuit comprend un transistor M4, de type NMOS par exemple, en série avec un transistor M5, de type PMOS par exemple. Un nœud de conduction du transistor M5 est configuré pour être relié au rail de tension VDD. Un nœud de commande N1 du transistor M5 est relié, préférablement connecté au point milieu N2 des transistors M5 et M4 par l'intermédiaire d'un interrupteur 432. Le transistor M4 a un nœud de conduction relié, préférablement connecté, à la masse.

Dans un exemple, les transistors M1 et M4 sont appairés ainsi que les transistors M3 et M5.

Dans l'exemple représenté, le deuxième circuit comprend un transistor M6, de type PMOS par exemple, et dont un nœud de conduction est configuré pour être relié au premier rail de tension VDD. Le deuxième circuit comprend en outre un transistor M7, de type NMOS par exemple, avec un nœud de conduction relié à la masse et un autre nœud de conduction relié, préférablement connecté, à son nœud de commande N7. Le nœud de commande du transistor M6 est relié, préférablement connecté, au nœud de commande N1 du transistor M5. Un interrupteur 434 relie un nœud de conduction du transistor M6 au nœud N7. Dans cet exemple, un interrupteur 402 relie le nœud de commande du transistor M5 au rail de tension VDD.

Dans l'exemple représenté, le deuxième circuit comprend par exemple un transistor M31, de type PMOS et avec un nœud de conduction relié au rail de tension VDD. Le deuxième circuit comprend un transistor M8, de type NMOS et dont un nœud de conduction est relié à la masse. Un interrupteur 438 relie un nœud de conduction du transistor M31 à un autre nœud de conduction du transistor M8. Un interrupteur 430 relie les nœuds de commande du transistor M3 et du transistor M31. Un interrupteur 422 relie le nœud de commande N3 du transistor M31 au rail de tension VDD, et un interrupteur 437 relie la masse aux nœuds de commande N7 des transistors M7, M8.

Dans un exemple non illustré, un transistor M2 est monté en montage cascode entre le transistor M1 et le transistor M3. Ce transistor monté en cascode protège le transistor M1 du vieillissement mais la structure M1+M2 est impactée par le vieillissement.

Les interrupteurs vont permettre de configurer le circuit en mode de test (premier état) ou en mode vieillissement (deuxième état). Dans le mode de vieillissement, dans l'exemple de la figure 4, seul les transistors M1 et M3 doivent vieillir. Dans le premier état, les interrupteurs 434, 432, 438 et 430, sont passants, et les interrupteurs 402, 437, 422 sont ouverts, c'est-à-dire non-passants. En outre, dans le premier état, le nœud de commande du transistor M4 est relié à un troisième rail de tension configuré pour recevoir une rampe de tension IN par exemple croissante et par exemple fournie par un convertisseur numérique analogique (DAC, Digital Analog Convertor) en anglais). Dans ce premier état, le nœud de commande du transistor M1 est relié au deuxième rail de tension V1. Dans un exemple, la tension V1 est comprise entre 0,5 et 1,5 V. Dans le premier état, le premier et le deuxième circuits forment un comparateur.

Dans le premier état, à l'aide de la rampe de tension appliquée sur le nœud de commande du transistor M4, lorsque la tension IN devient égale à la tension V1 (aux différences de fabrication près de M4 par rapport à M1), alors la tension de sortie OUT au niveau d'un nœud de sortie du circuit NOUT, situé entre le transistor M31 et l'interrupteur 438, varie selon un créneau. La valeur de tension Vf de la rampe de tension, ou le code du convertisseur numérique analogique, qui fait basculer le comparateur, est sauvegardée par exemple dans une mémoire d'un microcontrôleur.

Dans le deuxième état, les interrupteurs 434, 432, 438, 430, sont ouverts, et les interrupteurs 402, 437, 422 sont passants. Dans ce deuxième état, le nœud de commande du transistor M4 est cette fois-ci relié à la masse pour ne pas subir de vieillissement et le nœud de commande du transistor M1 est relié au deuxième rail de tension V1. Dans ce deuxième état, le transistor M1 opère normalement dans son circuit fonctionnel applicatif, c'est-à-dire qu'il subit un vieillissement, d'autant plus que la tension VDD est élevée.

Après que les premiers et deuxièmes circuits aient été placés dans le premier puis deuxième états, ils sont placés de nouveau dans le premier état. La nouvelle valeur de tension Vag de la rampe de tension, ou le code du convertisseur numérique analogique correspondante, qui fait basculer le comparateur, est sauvegardée. Si la tension Vag ou son code de convertisseur sont différents de la tension Vf ou de son code du convertisseur respectif, il est possible d'en déduire qu'un vieillissement a eu lieu dans le transistor M1, ou dans la structure M1+M2 si M2 est présent, et de pouvoir le quantifier. En effet le courant drain source à travers le transistor M1 est dépendent, que ce soit dans le mode linéaire ou en saturation, de la tension de seuil.

Dans l'exemple représenté, la présence du transistor M3 peut cependant induire des imprécisions sur la mesure du vieillissement du transistor M1.

La figure 5 représente un mode de réalisation d'un bloc de la figure 2. Plus particulièrement, la figure 4 représente un exemple des blocs 219 et 220.

L'exemple représenté comprend les transistors M1, M3, M4, M5, M6, M7 et les interrupteurs 402, 432, 434 et 437 agencés de façon similaire à la figure 4.

De façon additionnelle, le circuit de la figure 5 comprend un interrupteur 510 entre le point milieu N4 des transistors M3 et M1 et le nœud de conduction du transistor M3 qui n'est pas relié, ou connecté, au nœud VDD.

De plus, le circuit de la figure 5 comprend un transistor M32, de type PMOS par exemple, et dont un premier nœud de conduction est relié au premier rail de tension. Son nœud de commande N6 est relié au nœud de commande du transistor M3, et son deuxième nœud de conduction est relié, préférentiellement connecté, à un nœud de sortie NOUT2 du circuit. Ce deuxième nœud de conduction est relié au nœud de commande N6 par l'intermédiaire d'un interrupteur 518.

Le circuit de la figure 5 comprend en outre un transistor M82, de type NMOS par exemple, ayant un nœud de conduction relié, préférentiellement connecté, à la masse, et un autre nœud de conduction relié, préférentiellement connecté, au nœud de sortie NOUT2 par l'intermédiaire d'un interrupteur 524. Le nœud de commande du transistor M82 est configuré pour être relié au deuxième rail de tension mis à la deuxième tension V1.

Le circuit de la figure 5 comprend un transistor M81, de type NMOS par exemple, dont un premier nœud de conduction est relié à la masse, et dont un deuxième nœud de conduction est relié au nœud de sortie NOUT2 par l'intermédiaire d'un interrupteur 538. Le nœud de commande du transistor M81 est relié au nœud de commande du transistors M7.

Dans un exemple non illustré, le circuit de la figure 5 comprend le transistor 524 en montage cascode avec le transistor M1.

Facultativement, le circuit de la figure 5 comprend un transistor M3bis, de type PMOS par exemple, ayant un nœud de commande relié, préférentiellement connecté, au nœud de commande du transistor M32, un nœud de conduction relié au premier rail de tension VDD, et un autre nœud de conduction relié au point milieu N4 des transistors M1, M3 par l'intermédiaire d'un interrupteur 512.

En fonctionnement, dans le premier état, les interrupteurs 512, 518, 524 sont ouverts, et les interrupteurs 510, 538 sont passants. Dans le deuxième état, les interrupteurs 512, 518, 524 sont passants, et les interrupteurs 510, 538 ouverts.

L'exemple de la figure 5 permet de mettre les transistors M3 et M32 dans les mêmes conditions de vieillissement. L'évolution de la valeur de la tension de seuil du transistor M3 n'a plus d'impact sur la mesure de vieillissement du transistor M1.

Dans l'exemple représenté, le transistor M82 est utilisé pour le vieillissement et le transistor M81 est utilisé pour le premier état c'est-à-dire pour la mesure de vieillissement. Cela permet de minimiser l'erreur sur la mesure de l'évolution de la tension de seuil de M1.

Facultativement, le transistor M3bis est utilisé pendant le vieillissement et le transistor M3 est utilisé pour les mesures. Cela permet de minimiser encore davantage l'erreur sur la mesure de l'évolution de la tension de seuil de M1.

Un deuxième aspect porte sur une détermination d'un paramètre dynamique lié au vieillissement.

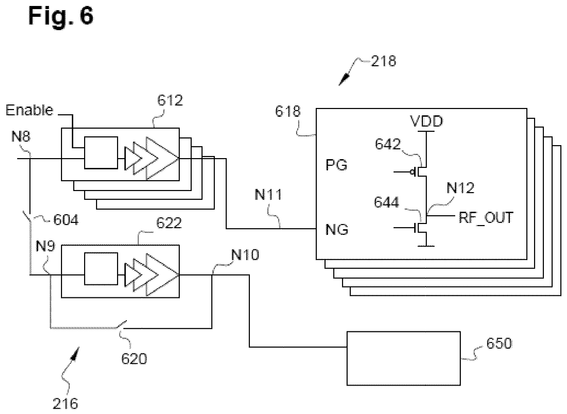

La figure 6 représente un mode de réalisation d'un bloc de la figure 2. Plus particulièrement, la figure 6 représente un exemple des blocs 216 et 218.

Dans l'exemple représenté, le bloc 218 comprend une ou plusieurs chaînes logiques 612 sélectionnables, composées chacune par exemple d'inverseurs, ou de circuits tampons, en série. Dans un exemple, le nombre de ces inverseurs ou circuits tampons est impair. Une des chaînes logiques est sélectionnable par exemple par un signal respectif Enable.

Dans l'exemple de la figure 6, la chaîne logique 612 relie un nœud d'entrée N8 d'un signal, par exemple NFC, à amplifier, à un nœud N11.

Dans l'exemple représenté, le bloc 218 comprend en outre un ou plusieurs circuits 618 ayant chacun un transistor PMOS 642 en série avec un transistor NMOS 644 référencé à la masse. Un nœud de conduction du transistor PMOS 642 est relié, préférentiellement connecté, au rail de tension de référence VDD et un point milieu N12 des transistors 642 et 644 correspond à un nœud de sortie du signal NFC amplifié RF_OUT. Les nœuds de commande du transistor 642 et du transistor 644 reçoivent respectivement un signal PG et NG en lien avec le signal présent sur le nœud N11 de la chaîne logique 612 respective.

Le circuit 612 correspond par exemple au premier circuit dont on souhaite connaître le vieillissement.

Dans l'exemple de la figure 6, le circuit 216 comprend un circuit 622, qui correspond par exemple au deuxième circuit, ayant une chaîne logique similaire à au moins une des chaînes logiques du circuit 612 dont on veut connaître le vieillissement. Un nœud de sortie N10 de la chaîne logique du circuit 622 est relié à un nœud d'entrée N9 de cette même chaîne logique par l'intermédiaire d'un interrupteur 620. Dans le cas où le nombre d'inverseurs ou de circuits tampons est impair, cela permet de former un oscillateur en anneau lorsque l'interrupteur est passant.

Dans l'exemple représenté, le nœud d'entrée N8 de la chaîne logique du premier circuit est relié au nœud d'entrée N9 de la chaîne logique du circuit 622 par l'intermédiaire d'un interrupteur 604. Dans cet exemple, le nœud de sortie N10 de la chaîne logique du circuit 622 est reliée à une charge 650 de valeur équivalente à celle du circuit 618 sélectionné. La charge 650 est cependant une autre charge, tout en étant de même valeur, différente de celle du circuit 618 pour des raisons de fonctionnement du circuit radiofréquence 618.

Dans l'exemple représenté, dans le premier état, l'interrupteur 620 est passant et l'interrupteur 604 est ouvert ; et dans le deuxième état, l'interrupteur 620 est ouvert et l'interrupteur 604 est passant.

Cela permet de former, dans le premier état, un oscillateur en anneau avec le circuit 622 et de pouvoir déterminer une fréquence ou un décalage temporel de cet l'oscillateur. La détermination de fréquence ou du décalage temporel est par exemple réalisée avec un compteur en comparaison avec une fréquence d'horloge d'un oscillateur à quartz.

Dans le deuxième état, le circuit 622 est soumis aux mêmes conditions de fonctionnement que le circuit 612 et vu que les circuits 612 et 622 voient la même charge, cela entraîne un vieillissement équivalent. En déterminant la fréquence ou le décalage temporel de l'oscillateur en anneau obtenu avec le deuxième circuit, avant et après vieillissement, alors il est possible de mesurer un indicateur de vieillissement car la variation de la tension de seuil de transistors composants les inverseurs ou tampons du circuit 622 influe sur leur vitesse de basculement.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, dans les exemples des figures 4 et 5, la personne du métier pourra changer les transistors NMOS en transistors PMOS, et vice versa, en inversant les tensions VDD, IN et V1.

Enfin, la mise en oeuvre pratique des modes de réalisation et variantes décrits est à la portée de la personne du métier à partir des indications fonctionnelles données ci-dessus. En particulier, pour ce qui est des chaînes logiques des circuits 612 et 622, il est possible d'envisager d'autres composants que des inverseurs ou des circuits tampons en série.

## Revendications

1. Circuit électronique, comprenant :
un premier circuit à tester ;
un deuxième circuit, ayant au moins des composants similaires au premier circuit, et relié au premier circuit ;
le circuit électronique étant configuré pour :
- adopter un premier état dans lequel une détermination d'au moins un indicateur de vieillissement du premier circuit est réalisée en utilisant le deuxième circuit, puis
- adopter un deuxième état dans lequel le premier circuit est soumis à des conditions de fonctionnement entraînant un vieillissement, puis
- adopter de nouveau le premier état,
- comparer les valeurs déterminées de l'indicateur, et
- adapter son fonctionnement en fonction du résultat de la comparaison.

2. Procédé de fonctionnement d'un circuit électronique comprenant un premier circuit à tester, un deuxième circuit similaire au premier circuit et relié au premier circuit, le procédé comprenant les étapes suivantes:
- placer le circuit électronique dans un premier état où une détermination d'au moins un indicateur de vieillissement du premier circuit est réalisée en utilisant le deuxième circuit, puis
- placer le circuit électronique dans un deuxième état où le premier circuit est soumis à des conditions de fonctionnement entraînant un vieillissement, puis
- placer de nouveau le circuit électronique dans le premier état,
- comparer les valeurs déterminées de l'indicateur; et
- adapter le fonctionnement du circuit électronique en fonction du résultat de la comparaison.

3. Circuit électronique selon la revendication 1, ou procédé selon la revendication 2, dans lequel, si la comparaison indique un vieillissement du premier circuit, alors des performances du circuit électronique sont abaissées.

4. Circuit électronique selon la revendication 1 ou 3, ou procédé selon la revendication 2 ou 3, dans lequel le premier et le deuxième circuits comprennent au moins un transistor, ledit indicateur étant une tension de seuil dudit au moins un transistor.

5. Circuit électronique selon l'une quelconque des revendications 1 ou 3 ou 4, ou procédé selon l'une quelconque des revendications 2 à 4, dans lequel, dans le deuxième état, le deuxième circuit n'est pas soumis auxdites conditions de fonctionnement entraînant un vieillissement.

6. Circuit électronique selon l'une quelconque des revendications 1 ou 3 à 5, ou procédé selon l'une quelconque des revendications 2 à 5, dans lequel :
le premier circuit comprend un premier transistor (M1) de type NMOS en série avec un deuxième transistor (M3) de type PMOS, un premier nœud de conduction du deuxième transistor (M3) étant configuré pour être relié à un premier rail de tension mis à une première tension de référence (VDD), un nœud de commande du deuxième transistor (M3) étant connecté au point milieu des premier et deuxièmes transistors (M1, M3) ;
le deuxième circuit comprend un troisième transistor (M4) de type NMOS en série avec un quatrième transistor (M5) de type PMOS, un nœud de conduction du quatrième transistor étant configuré pour être relié au premier rail de tension ;
les premiers et troisièmes transistors (M1, M4) ayant chacun un nœud de conduction relié à la masse.

7. Circuit électronique ou procédé selon la revendication précédente, dans lequel le premier et le troisième transistors (M1, M4) sont appairés et dans lequel le deuxième et le quatrième transistors (M3, M5) sont appairés.

8. Circuit électronique ou procédé selon la revendication 6 ou 7, dans lequel le deuxième circuit comprend :
- un cinquième transistor (M6), de type PMOS et ayant un nœud de conduction configuré pour être relié au premier rail de tension ; et
- un sixième transistor (M7), de type NMOS, avec un nœud de conduction relié à la masse et un autre nœud de conduction relié à son nœud de commande, le nœud de commande du cinquième transistor (M6) étant connecté au nœud de commande du quatrième transistor (M5), un premier interrupteur (434) reliant un nœud de conduction du cinquième transistor (M6) à un nœud de conduction du sixième transistor (M7), un deuxième interrupteur (432) reliant le nœud de commande du quatrième transistor (M5) au point milieu des troisièmes et quatrièmes transistors (M4, M5), un troisième interrupteur (402) reliant le nœud de commande du quatrième transistor (M5) au premier rail de tension.

9. Circuit électronique ou procédé selon la revendication 8, dans lequel le deuxième circuit comprend :
- un septième transistor (M31), de type PMOS et ayant un nœud de conduction configuré pour être relié au premier rail de tension ; et
- un huitième transistor (M8), de type NMOS et ayant un nœud de conduction relié à la masse, un quatrième interrupteur (438) reliant un nœud de conduction du septième transistor (M31) à un nœud de conduction du huitième transistor (M8), un cinquième interrupteur (437) reliant la masse au nœud de commande des sixième et huitième transistors (M7, M8), un sixième interrupteur (430) reliant les nœuds de commande des deuxième (M3) et septième (M31) transistors, un septième interrupteur (422) reliant le nœud de commande du septième transistor (M31) au premier rail de tension.

10. Circuit électronique ou procédé selon la revendication 9, dans lequel un neuvième transistor est monté en montage cascode avec le premier transistor (M1).

11. Circuit électronique ou procédé selon la revendication 8, dans lequel le deuxième circuit comprend :
- un dixième transistor (M32), de type PMOS, dont un premier nœud de conduction est relié au premier rail de tension, dont le nœud de commande (N6) est relié au nœud de commande du deuxième transistor (M3), et dont un deuxième nœud de conduction (NOUT) est relié à son nœud de commande (N6) par l'intermédiaire d'un huitième interrupteur (518) ;
- un onzième transistor (M82), de type NMOS, ayant un nœud de conduction relié à la masse, un autre nœud de conduction relié au deuxième nœud de conduction (NOUT) du onzième transistor (M32) par l'intermédiaire d'un neuvième interrupteur (524), et un nœud de commande configuré pour être relié à un deuxième rail de tension mis à une deuxième tension (V1) ; et
- un douzième transistor (M81), de type NMOS, dont un premier nœud de conduction est relié à la masse, dont un deuxième nœud de conduction (NOUT) est relié au deuxième nœud de conduction du dixième transistor (M32) par l'intermédiaire d'un dixième interrupteur (538), et dont un nœud de commande est relié au nœud de commande du sixième transistors (M7).

12. Circuit électronique ou procédé selon la revendication précédente, dans lequel le deuxième circuit comprend un treizième transistor (M3bis), de type PMOS, ayant un nœud de commande relié au nœud de commande du onzième transistor (M32), un nœud de conduction relié au premier rail de tension, et un autre nœud de conduction relié au point milieu (N4) des premiers et deuxièmes transistors (M1, M3) par l'intermédiaire d'un onzième interrupteur (512) ;
un douzième interrupteur (510) reliant le point milieu (N4) des premiers et deuxièmes transistors (M1, M3) et un deuxième nœud de conduction du deuxième transistor (M3).

13. Circuit électronique ou procédé selon la revendication 9, dans lequel :
- dans le premier état, le premier et le deuxième interrupteurs (434, 432) sont passants, et le troisième et le cinquième interrupteurs (402, 437) sont ouverts, le nœud de commande du troisième transistor (M4) étant relié à un troisième rail de tension configuré pour recevoir une rampe de tension (IN), et le nœud de commande du premier transistor (M1) étant relié au deuxième rail de tension (V1) ; et
- dans le deuxième état, le premier et le deuxième interrupteurs (434, 432), sont ouverts, et le troisième et le cinquième interrupteurs (402, 437) sont passants, le nœud de commande du troisième transistor (M4) étant relié à la masse et le nœud de commande du premier transistor (M1) étant relié au deuxième rail de tension (V1).

14. Circuit électronique ou procédé selon la revendication précédente, dans lequel :
- dans le premier état, le quatrième, et le sixième interrupteurs (438, 430) sont passants, et le septième interrupteur (422) est ouvert ; et
- dans le deuxième état, le quatrième et le sixième interrupteurs (438, 430) sont ouverts, et le septième interrupteur (422) est passant.

15. Circuit électronique ou procédé selon la revendication 11 ou 12, dans lequel :
- dans le premier état, le huitième et le neuvième interrupteurs (518, 524) sont ouverts, et le dixième interrupteur (538) est passant, et
- dans le deuxième état, le huitième et le neuvième interrupteurs sont passants, et le dixième interrupteur est ouvert.

16. Circuit électronique ou procédé selon l'une quelconque des revendications 12, ou 13 à 15 dans leur dépendance à la revendication 12, dans lequel :
- dans le premier état, le onzième interrupteur (512) est ouvert, et le douzième interrupteur (510) est passant, et
- dans le deuxième état, le onzième interrupteur (512) est passant, et le douzième interrupteur (510) est ouvert.

17. Circuit électronique selon la revendication 1 ou 3, ou procédé selon la revendication 2 ou 3, dans lequel, dans le deuxième état, le deuxième circuit est également soumis auxdites conditions de fonctionnement entraînant un vieillissement.

18. Circuit électronique ou procédé selon la revendication précédente, dans lequel :
- le premier et le deuxième circuits comprennent chacun une chaîne logique similaire ;
- un nœud de sortie de la chaîne logique du deuxième circuit est relié à un nœud d'entrée de cette même chaîne logique par l'intermédiaire d'un treizième interrupteur (620) de sorte à former un oscillateur en anneau lorsque le treizième interrupteur est passant ;
- un nœud d'entrée (N8) de la chaîne logique du premier circuit est relié au nœud d'entrée (N9) de la chaîne logique du deuxième circuit par l'intermédiaire d'un quatorzième interrupteur (604); et
- le nœud de sortie de la chaîne logique du deuxième circuit et un nœud de sortie de la chaîne logique du premier circuit sont reliés à une charge différente et de valeur équivalente.

19. Circuit électronique ou procédé selon la revendication précédente, dans lequel la chaîne logique du premier et du deuxième circuits comprend un nombre impair d'inverseurs, ou de circuits tampons, en série.

20. Circuit électronique ou procédé selon la revendication précédente, dans lequel ledit indicateur est une fréquence ou un décalage temporel de l'oscillateur.

21. Circuit électronique ou procédé selon l'une quelconque des revendications 18 à 20, dans lequel, dans le premier état, l'interrupteur (620) est passant et l'interrupteur 604 est ouvert ; et
dans le deuxième état, l'interrupteur (620) est ouvert et l'interrupteur (604) est passant.

22. Circuit électronique selon l'une quelconque des revendications 1 ou 3 à 21, ou procédé selon l'une quelconque des revendications 2 à 21, dans lequel la détermination dudit au moins un indicateur de vieillissement du premier circuit est réalisée en mesurant un indicateur de vieillissement du deuxième circuit.

23. Procédé d'utilisation du circuit électronique selon l'une quelconque des revendications 1 ou 3 à 22, comprenant l'utilisation du deuxième circuit pour déterminer le vieillissement du premier circuit et adapter le fonctionnement du circuit électronique en fonction du vieillissement déterminé.
